# EUROPEAN PATENT APPLICATION

(11) **EP 2 492 670 A1**
(43) Date of publication of application: **29.08.2012**
(21) Application number: 12153004.2
(22) Date of filing: 30.01.2012
(51) Int. Cl.: G01N 25/66

(54) **Condensation sensing device, electronic apparatus, and condensation sensing method**

(30) Priority: 23.02.2011 JP 2011037435
(71) Applicant: Fujitsu Limited, Kawasaki-shi, Kanagawa 211-8588 (JP)
(72) Inventor: So, Tsuyoshi, Kawasaki-shi, Kanagawa 211-8588 (JP); Kubo, Hideo, Kawasaki-shi, Kanagawa 211-8588 (JP)
(74) Representative: Ward, James Norman

(57) **Abstract**

A condensation sensing device that detects a water droplet to sense the condensation, the condensation sensing device comprising: a surface having a recesses and protrusions; and a water droplet detector that detects a water droplet guided by any of the recesses on the surface.

## Description

### FIELD

The embodiments disclosed hereafter are related to a condensation sensing device that detects water droplets produced by condensation to sense the condensation.

### BACKGROUND

When the temperature of a component of an electronic apparatus decreases below the dew point of the surrounding atmosphere, condensation occurs on the component of the electronic apparatus. Moisture produced by the condensation could cause corrosion of a metal part in the electronic apparatus, short circuit between electrodes in an electric circuit in the electronic apparatus, and other faults resulting from the condensation.

In general, the temperature and humidity of the environment in which a liquid-cooled electronic apparatus is installed and the temperature of the coolant are controlled so as to avoid condensation. However, if an air conditioner malfunctions or a coolant output device experiences an abnormal temperature, the temperature of the coolant decreases below the dew point at the electronic apparatus, and condensation may occur inside the electronic apparatus. Even under such a condition, the electronic apparatus may be turned on or kept operating. In that case, when the amount of water produced by the condensation in the electronic apparatus exceeds a certain limit, short circuit could occur between electrodes in an electric circuit in the electronic apparatus, and the short circuit may cause malfunction of the electric circuit, burnout of the electric circuit, or other failures.

To prevent such faults resulting from condensation, it has been proposed to provide a condensation sensor in an electronic apparatus to sense condensation, have been proposed. In this proposal, when the condensation sensor senses condensation, the electronic apparatus may be prevented from turning on, or the inside of the electronic apparatus may be dried.
There are a variety of types of condensation sensors. One type of known condensed water sensor senses condensation by sensing that water droplets produced by the condensation flow out and reach a sensing portion. A condensed water sensor of this type typically includes a measurement plate made of metal or any other material on which condensation tends to occur and a water droplet sensor (liquid sensor) provided in part of the measurement plate. That is, the measurement plate has a structure in which water droplets produced by condensation flow to the water droplet sensor, which detects the water droplets having flowed thereto to sense the condensation.

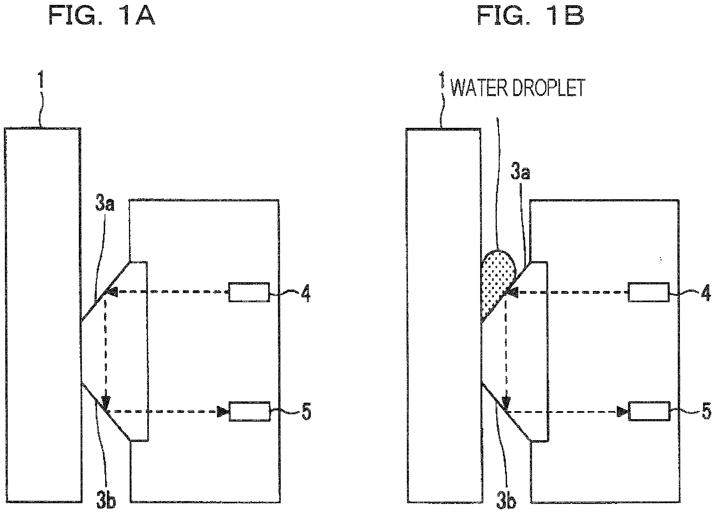

FIGS. 1A and 1B describe the principle based on which the condensed water sensor described above senses condensation. A measurement plate 1 is, for example, a plate-shaped member made of a metal or a material on which condensation tends to occur. Water droplets produced by condensation grow on the measurement plate 1 and flow down along the surface of the measurement plate 1. A water droplet sensor 2 includes a light guide 3 attached to a lower portion of the measurement plate 1, a light source 4 that emits light toward the light guide 3, and a receiver 5 that receives light reflected off the light guide 3 and detects the intensity of the received light.

The light guide 3 is a prismatic member and has an inclined surface 3a that reflects the light from the light source 4 and another inclined surface 3b that further reflects the reflected light toward the receiver 5. Specifically, the light emitted from the light source 4 is reflected off the inclined surface 3a, further reflected off the inclined surface 3b, and incident on the receiver 5. The receiver 5 detects the intensity of the light incident thereon and outputs a detection result.

When no condensation has occurred on the measurement plate 1 or the amount of condensation is small, there is an air gap between the inclined surface 3a of the light guide 3 and the surface of the measurement plate 1, as depicted in FIG. 1A. The light emitted from the light source 4 is therefore totally reflected off the inclined surface 3a to enter the receiver 5, which then receives light having an intensity substantially equal to the intensity of the light emitted from the light source 4.

On the other hand, when condensation occurs on the measurement plate 1, and water droplets are produced and flow down, the water droplets having flowed down are accumulated between the inclined surface 3a of the light guide 3 and the surface of the measurement plate 1, as depicted in FIG. 1B. When water droplets attach to the inclined surface 3a of the light guide 3, part of the light incident on the inclined surface 3a passes therethrough to prevent total reflection from occurring at the inclined surface 3a. As a result, the intensity of the light reflected off the inclined surface 3a decreases, and the intensity of the light further reflected off the inclined surface 3b and received by the receiver 5 is therefore lower than the intensity of the light emitted from the light source 4.

As described above, detecting any decrease in the intensity of the light incident on the receiver 5 allows the sensor to sense that water droplets have attached to the inclined surface 3a and hence sense the condensation.

As an example of the method for detecting that water droplets have attached based on the light transmittance that changes when the water droplets have attached as described above, a method for detecting water droplets on the windshield of an automobile has been proposed. The method for detecting water droplets disclosed in Japanese Laid-Open Patent Publication No. 10-311786, however, is a method for detecting water droplets that attach to the windshield of an automobile, such as raindrops, and is not a method for detecting water droplets produced by condensation.

Japanese Laid-Open Patent Publication No. 10-311786

In the method for detecting water droplets produced by condensation on the measurement plate 1, condensation may be detected only after large water droplets are formed by the condensation, as depicted in FIGS. 1A and 1B. Before a water droplet grows large enough to flow down under its own weight is formed, however, the environment may have already reached a state in which a large number of small water droplets may be produced by the condensation.

It may take time, typically several minutes to several tens of minutes, for water droplets produced by condensation to start flowing and to be detected by the water droplet sensor in a certain amount, although the period depends on the temperature and humidity of the environment in which the water droplet sensor is installed. Further, only a limited area may be available for collecting water droplets produced by condensation in an electronic apparatus having densely packed components; in such a case, even all collected water droplets produced in an initial stage of condensation may not produce enough amount of water to be detectable to the water droplet sensor. In this case, it is requested to keep collecting the water droplets produced by the condensation, and it could take a long period to collect a sufficient amount of water.

### SUMMARY

It is conceivable that condensation has already occurred in the electronic apparatus when the condensed water sensor described above senses the condensation.
The purpose of these embodiments is for providing a condensation sensing device capable of detecting condensation more quickly.

According to one aspect of the embodiments, there is provided a condensation sensing device that detects water droplets produced by condensation to sense the condensation. The condensation sensing device includes a condensation producing section having a surface on which condensation occurs, recesses and protrusions formed on the surface of the condensation producing section, and a water droplet detecting section that detects water droplets produced by the condensation that occurs in the condensation producing section. The condensation sensing device is installed so that the surface of the condensation producing section extends in a direction that intersects a horizontal direction, and that the recesses and protrusions are disposed above the water droplet detecting section.

Another aspect of the embodiments, there is provided a condensation sensing method for sensing condensation in an electronic apparatus. The method includes causing condensation to occur on a surface of a condensation producing section, causing water droplets produced by the condensation to move along recesses and protrusions formed on the surface of the condensation producing section so that the water droplets are introduced into a water droplet detecting section, and detecting the water droplets by using the water droplet detecting section and outputting a condensation detection signal.

### BRIEF DESCRIPTION OF DRAWINGS

FIGS. 1A and 1B describe the principle based on which water droplets are detected;
FIG. 2 depicts a schematic configuration of an electronic apparatus according to a first embodiment;
FIG. 3 is a front view of a condensation sensing device depicted in FIG. 2;
FIG. 4 is a cross-sectional view taken along the line IV-IV depicted in FIG. 3;
FIG. 5 is a cross-sectional view depicting another example of recesses and protrusions;
FIG. 6 is a flowchart of a condensation sensing procedure for sensing condensation by using the condensation sensing device;
FIG. 7 depicts graphs representing results obtained by measuring the amount of water that reaches a water droplet sensor (the amount of sensor reaching water) for a variety of shapes of the recesses and protrusions of a condensed water collector plate;
FIG. 8 is a front view of a condensed water collector plate having curved recesses and protrusions or grooves;
FIG. 9 is a front view of a condensed water collector plate according to a second embodiment;
FIG. 10 is a side view of the condensed water collector plate depicted in FIG. 9;
FIG. 11 is a front view of a condensed water collector plate having groove-shaped recesses and protrusions on which small projections are further provided;
FIG. 12 is a side view of the condensed water collector plate depicted in FIG. 11; and
FIG. 13 is a front view of a condensed water collector plate having inclined recesses and protrusions or grooves extending therealong and projections provided on the recesses and protrusions or the grooves.

### DESCRIPTION OF THE EMBODIMENTS

Embodiments will next be described with reference to the drawings.

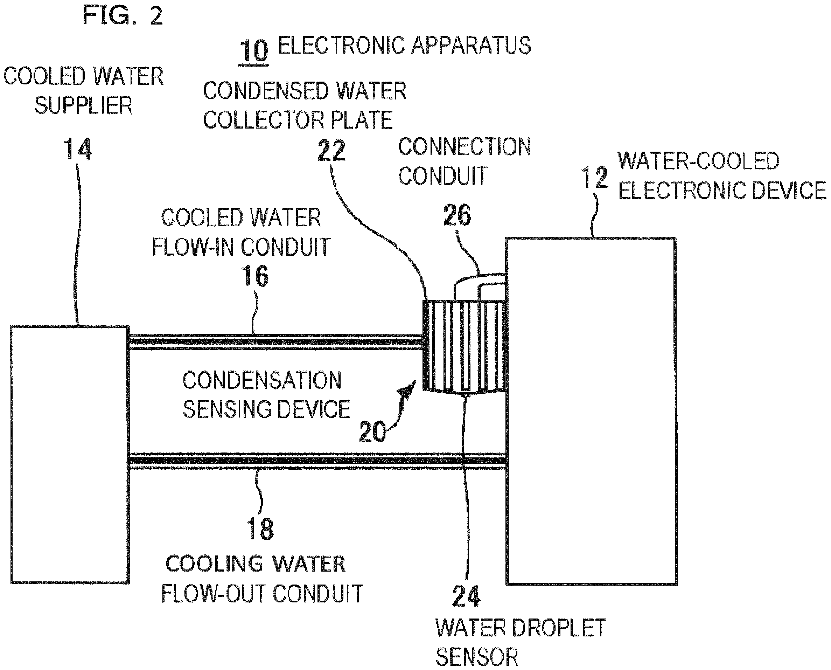

FIG. 2 depicts a schematic configuration of an electronic apparatus according to a first embodiment. The electronic apparatus depicted in FIG. 2 is a server or an electronic apparatus including a water-based cooling mechanism.

An electronic apparatus 10 depicted in FIG. 2 includes a water-cooled electronic device 12 and a cooled water supplier 14 that supplies cooled water to the water-cooled electronic device 12. The water-cooled electronic device 12 corresponds, for example, to the server described above. A cooling water path (not depicted) through which cooling water circulates is provided in the water-cooled electronic device 12, and low-temperature cooling water (hereinafter referred to as cooled water) produced by the cooled water supplier 14 is supplied into the cooling water path through a cooled water flow-in conduit 16. When the cooled water flows through the cooling water path, heat-generating parts and other components inside the water-cooled electronic device 12 are cooled. The cooled water heated in the water-cooled electronic device 12 into high-temperature water (hereinafter referred to as heated water) flows through a cooling water flow-out conduit 18 back to the cooled water supplier 14, where the heated water is cooled into cooled water again and supplied to the water-cooled electronic device 12.

The cooled water supplier 14, which is a device that cools the heated water into cooled water by using a known cooling mechanism, is not described in detail. The water-cooled electronic device 12 is a server, a computer, or an electronic apparatus including a known water-based cooling mechanism, and the internal structure of the water-cooled electronic device 12 is not described in detail.

In the present embodiment, a condensation sensing device 20 that senses condensation in the water-cooled electronic device 12 is provided. The condensation sensing device 20 is disposed between the cooled water flow-in conduit 16, through which cooled water from the cooled water supplier 14 is supplied, and the water-cooled electronic device 12. The condensation sensing device 20 includes a condensed water collector plate 22 and a water droplet sensor (water droplet detecting section) 24 provided in a lower portion of the condensed water collector plate 22.

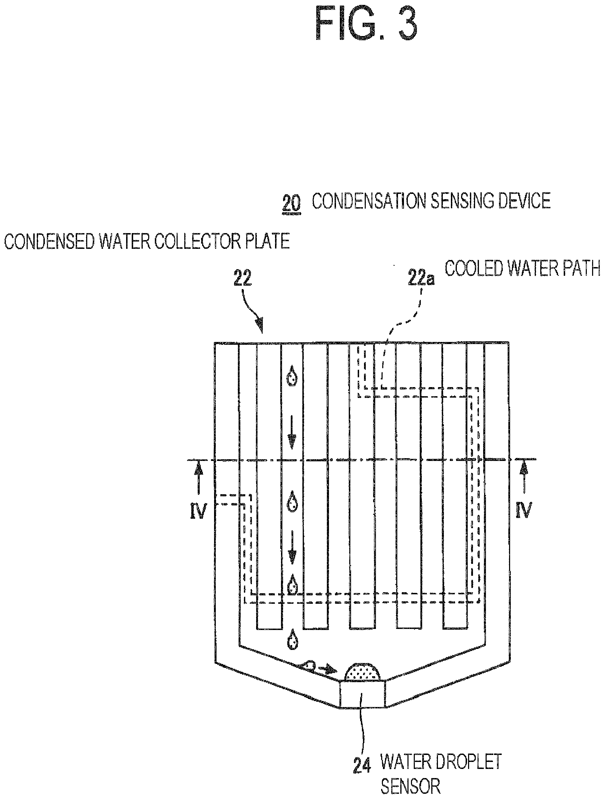

The condensed water collector plate 22 is a plate-shaped member made of stainless steel, aluminum, or a material on the surface of which condensation tends to occur, and a cooled water path 22a (see FIG. 3), through which cooled water flows, is formed in the condensed water collector plate 22. One end of the cooled water path 22a is connected to the cooled water flow-in conduit 16 described above, and the other end of the cooled water path 22a is connected to a connection conduit 26. The connection conduit 26 is connected to the cooling water path in the water-cooled electronic device 12. Cooled water supplied from the cooled water supplier 14 through the cooled water flow-in conduit 16 therefore first enters the cooled water path 22a in the condensed water collector plate 22, flows inside the condensed water collector plate 22, and then is supplied to the cooling water path in the water-cooled electronic device 12 via the connection conduit 26. The condensed water collector plate 22 is therefore cooled with the cooled water supplied from the cooled water supplier 14 so that the temperature of the condensed water collector plate 22 approaches the temperature of the cooled water.

The condensed water collector plate 22 is disposed in the vicinity of an air intake opening of the water-cooled electronic device 12, and the environment (temperature, humidity) around the condensed water collector plate 22 is therefore the same as or similar to the environment (temperature, humidity) in the water-cooled electronic device 12. In this configuration, when condensation occurs in the water-cooled electronic device 12, so does on the surface of the condensed water collector plate 22. The condensed water collector plate 22 is an example of a condensation producing section that allows condensation to occur.

When condensation occurs on the surface of the condensed water collector plate 22 and proceeds, water droplets are produced. The water droplets grow as the condensation proceeds and eventually flow down along the surface of the condensed water collector plate 22 because surface tension may not hold large water droplets. The flowing water droplets are guided to and accumulated on the water droplet sensor 24 provided in a lower portion of the condensed water collector plate 22. When the amount of accumulated water droplet reaches a predetermined value, the water droplet sensor 24 responds, senses the water droplets, and outputs a signal representing that water droplets have been sensed.

To guide water droplets produced by condensation to the water droplet sensor 24 in the lower portion as described above, it is preferable to orient the condensed water collector plate 22 in such a way that the surface where condensation occurs vertically extends. The condensed water collector plate 22, however, does not necessarily vertically extend but need only not horizontally extend, which does not allow water droplets to flow. That is, the surface of the condensed water collector plate 22 may extend in a direction that intersects the horizontal direction.

FIG. 3 is a front view of the condensed water collector plate 22. Recesses and protrusions are formed on the surface of the condensed water collector plate 22. The recesses and protrusions (including elongated recesses or grooves) extend from the upper edge to the lower edge of the vertically oriented condensed water collector plate 22. Water droplets into which condensed water on the surface of the condensed water collector plate 22 has grown flow along the recesses and protrusions on the surface to the water droplet sensor 24, which is an example of a water droplet detecting section, and accumulate there.

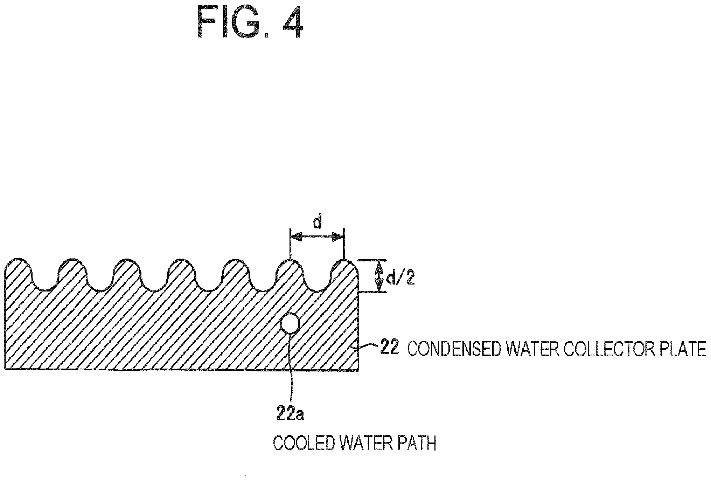

FIG. 4 is a cross-sectional view taken along the line IV-IV in FIG. 3 and depicts a cross section of the recesses and protrusions. In the example depicted in FIG. 4, the difference in height between the recesses and the protrusions is d/2, where d represents the distance (interval) between the recesses and the protrusions. Forming recesses and protrusions that extend from the upper edge to the lower edge on the surface of the condensed water collector plate 22 allows the surface area to increase and the growth of water droplets produced by condensation on the surface is encouraged as compared with a case where the surface is a simple flat surface, whereby the water droplets start flowing more quickly. Further, the flowing water droplets are guided by the recesses and protrusions and directed toward the lower edge of the condensed water collector plate 22, whereby the water droplets tend to quickly reach the water droplet sensor 24 disposed at the lower edge. Forming the recesses and protrusions on the surface of the condensed water collector plate 22 therefore allows the water droplet sensor 24 to receive a detectable amount of water quickly after the condensation occurs, whereby the condensation may be quickly sensed.

When the width of each of the recesses of the recesses and protrusions is too small, water droplets are left in the recesses and do not tend to flow downward along the recesses and protrusions. It is therefore preferable to set the width of each of the recesses to be greater than the diameter of each flowing water droplet.

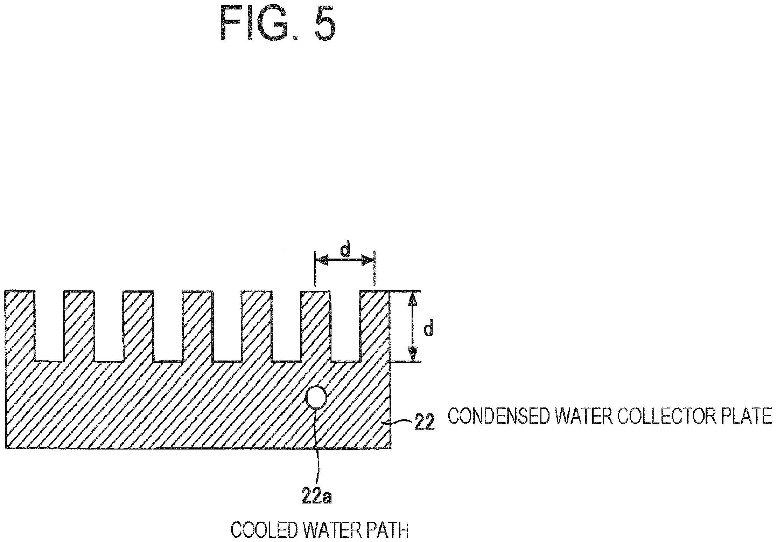

FIG. 5 is a cross-sectional view depicting another example of the recesses and protrusions, in which each of the recesses has a groove shape. In the example depicted in FIG. 5, the distance (interval) between the recesses and protrusions is set at d, and the depth of each of the grooves (corresponding to the difference in height between the recesses and protrusions) is set at the same value d. The surface area may be increased by increasing the difference in height between the recesses and protrusions. In the cross-sectional shape depicted in FIG. 5, in which each of the recesses is taken as a groove, the space between adjacent protrusions may be considered to correspond to a recess. That is, grooves may be formed on the surface of the condensed water collector plate 22 to provide recesses and protrusions, or protrusions may be formed to provide recesses and protrusions.

The cross-sectional shape of the recesses and protrusions is not limited to those depicted in FIGS. 4 and 5 and may be any shape that increases the surface area to encourage condensation and guides water droplets downward.

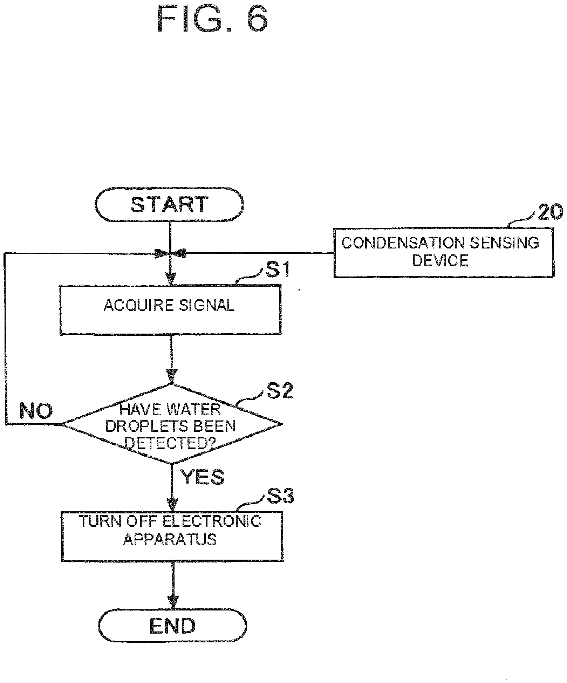

A condensation sensing method for sensing condensation by using the condensation sensing device will be described with reference to FIG. 6. FIG. 6 is a flowchart of a condensation sensing procedure.

After the condensation sensing procedure starts, a controller of the electronic apparatus 10 first acquires a signal from the condensation sensing device 20 (step S1). The controller of the electronic apparatus 10 then judges whether or not the signal from the condensation sensing device 20 represents that water droplets have been detected (step S2). When the judgment result in step S2 shows that the signal from the condensation sensing device 20 does not represent that water droplets have been detected, the control returns to step S1 and the controller acquires a signal from the condensation sensing device 20 again.

On the other hand, when the judgment result in step S2 shows that the signal from the condensation sensing device 20 represents that water droplets have been detected, the control proceeds to step S3. In step S3, the controller shuts off (turns off) the electronic apparatus 10. At this point, a display device may notify an operator or an alarm may be issued to notify the operator that condensation has occurred. Alternatively, instead of turning off the electronic apparatus 10, the inside of the water-cooled electronic device 12 may be dried so that the amount of condensation decreases.

According to the condensation sensing method described above, since the condensation sensing device 20 described above is used to sense condensation, condensation may be sensed quickly after the condensation occurs. That is, condensation is quickly sensed by using the condensed water collector plate 22, on which recesses and protrusions are provided, to collect water droplets produced by the condensation. As a result, before the amount of condensation in the water-cooled electronic device 12 (the amount of water produced by condensation) reaches a value that causes a problem, the water-cooled electronic device 12 may be turned off or any other suitable measures may be taken. Faults resulting from the condensation may therefore be reliably prevented.

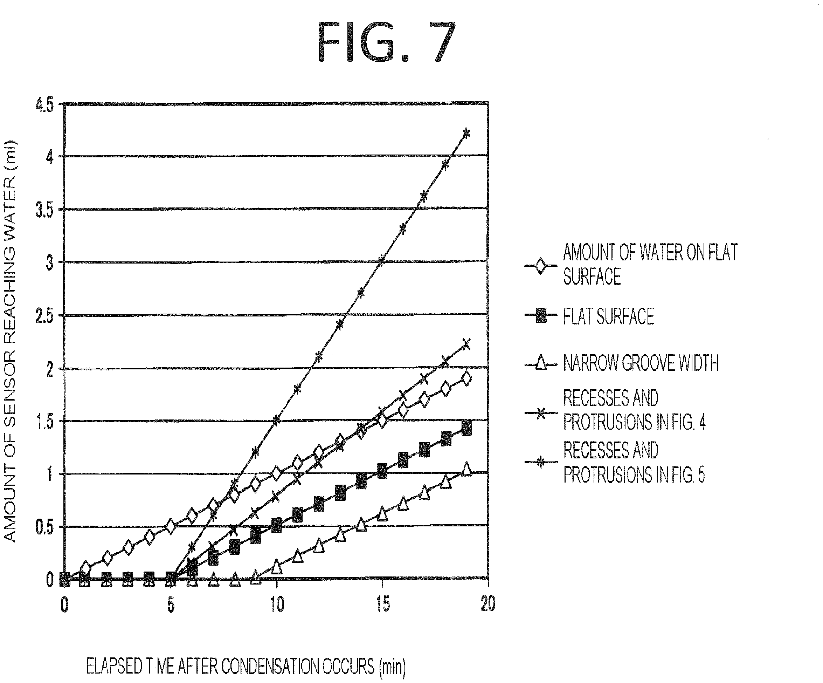

FIG. 7 depicts graphs representing results obtained by calculating the amount of water that reaches the water droplet sensor 24 (the amount of sensor reaching water) for a variety of shapes of the recesses and protrusions of the condensed water collector plate 22 described above. The calculation conditions are as follows:

Environment in which electronic apparatus is installed:
When an air conditioner normally operates, the room temperature is 25°C and the humidity is 50% (dew point: 13.9_{°}C).
When the air conditioner malfunctions, the room temperature is 28°C and the humidity is 70% (dew point: 22.0°C).
   - Temperature of cooled water: 16°C
   - Size of condensed water collector plate: 50 mm × 50 mm
   - Shape of vertically extending recesses and protrusions: d = 10 mm
   - Thickness of water layer immediately before it starts flowing: 0.2 mm (size of water droplet → φ0.4 mm)
   - Amount of water is requested for water droplet sensor to detect water droplet: 1 ml
The line connecting the symbols "white diamond" in FIG. 7 represents increase in the amount of water produced by condensation on the condensed water collector plate 22 with a flat surface. The graph shows that the amount of water on the surface of the condensed water collector plate 22 increases with time after the condensation occurs. The line connecting the symbols "black square" in FIG. 7 represents the amount of water that reaches the water droplet sensor 24 when the surface of the condensed water collector plate 22 is flat. The graph shows that water droplets start reaching the water droplet sensor 24 about five minutes after the condensation occurs.

The line connecting the symbols x in FIG. 7 represents the amount of water that reaches the water droplet sensor 24 when the recesses and protrusions depicted in FIG. 4 are provided on the surface of the condensed water collector plate 22. The graph shows that water droplets start reaching the water droplet sensor 24 about five minutes after the condensation occurs and that the amount of water that reaches the water droplet sensor 24 then increases more quickly than the case where the surface is flat. The line connecting the symbols * in FIG. 7 represents the amount of water that reaches the water droplet sensor 24 when the recesses and protrusions depicted in FIG. 5 are provided on the surface of the condensed water collector plate 22. The graph shows that water droplets start reaching the water droplet sensor 24 about five minutes after the condensation occurs and that the amount of water that reaches the water droplet sensor 24 then increases more quickly than the case where the recesses and protrusions depicted in FIG. 4 are provided. In conclusion, in the example depicted in FIG. 7, the amount of water that reaches the water droplet sensor 24 more quickly increases in the case where the recesses and protrusions depicted in FIG. 4 or 5 are provided than the case where the surface is flat, and hence that condensation may be sensed more quickly. In comparison between the case of the recesses and protrusions depicted in FIG. 4 and the case in FIG. 5, the amount of water that reaches the water droplet sensor 24 via the recesses and protrusions depicted in FIG. 5 more quickly increases than via the recesses and protrusions depicted in FIG. 4, and condensation may therefore be more quickly sensed in the former case than in the latter case.

The line connecting the symbols "white triangle" in FIG. 7 represents the amount of water that reaches the water droplet sensor 24 when each of the recesses of the recesses and protrusions (grooves) has a reduced width. When the width of each of the recesses of the recesses and protrusions (width of groove) is narrow, water droplets attach to both walls of each of the recesses and a capillary action occurs. In this case, the water droplets do not tend to flow down by gravity. It therefore takes a long period, about nine minutes, for the water droplets to reach the water droplet sensor 24. It is therefore requested to set the width of each of the recesses of the recesses and protrusions to be greater than the diameter of a flowing-down water droplet.

The calculation results depicted in FIG. 7 also show the follow points:

1) When the temperature of the condensed water collector plate (16°C) decreases below the dew point of 22.0°C, condensation occurs and the amount of water produced by the condensation increases in proportion to the time after the condensation occurs.

2) The water layers on the three types of surfaces, "flat surface," "recesses and protrusions in FIG. 4," and "recesses and protrusions in FIG. 5" have the same thickness and increase to 0.2 mm five minutes after the condensation occurs, and the water droplets start flowing down. Since the water droplets flowing along the three types of surfaces have the same surface density, water droplets flowing along a surface having a greater area result in a greater amount of water that reaches the water droplet sensor.

3) In the case of "narrow groove width" (groove width = 0.2 mm), water droplets do not flow down due to a capillary action until part of the water droplets attaches to the grooves and fills them (nine minutes), and the water droplets start flowing after nine minutes.

A total period ta from the point when condensation starts to the point when the water droplet sensor responds is ta = t0+t1. In the expression, t0 represents the period from the point when condensation starts to the point when water droplets start flowing, and t1 represents the period from the point when the water droplets start flowing to the point when the water droplet sensor responds. The following table summarizes calculation results for the three types of surfaces, "flat surface," "recesses and protrusions in FIG. 4," and "recesses and protrusions in FIG. 5." It is noted that the period t0, which is the period from the point when condensation starts to the point when water droplets start flowing, is five minutes.

**[Table 1]**

| | Surface area | Area ratio | t1 (min) | Total period ta (min) | Total period ratio |
|---|---|---|---|---|---|
| Flat surface | 2,500 | 1.00 | 10.00 | 15.00 | 100.00% |
| Recesses and protrusions in FIG. 4 | 3,927 | 1.57 | 6.37 | 11.37 | 75.77% |
| Recesses and protrusions in FIG. 5 | 7,500 | 3.00 | 3.33 | 8.33 | 55.56% |

As described above, using the condensed water collector plate having recesses and protrusions according to the present embodiment allows the condensation sensing period to shorten by three to six minutes as compared with the case where a condensed water collector plate having a flat surface of related art is used. It is, however, noted that the period to be shortened depends on a variety of conditions and is presented by way of example under the calculation conditions described above. The electronic apparatus may be turned off earlier by the shortened condensation sensing period, whereby faults resulting from condensation may be reliably prevented. After the electronic apparatus is turned off, the inside of the electronic apparatus may be dried and the electronic apparatus may then resume normal operation.

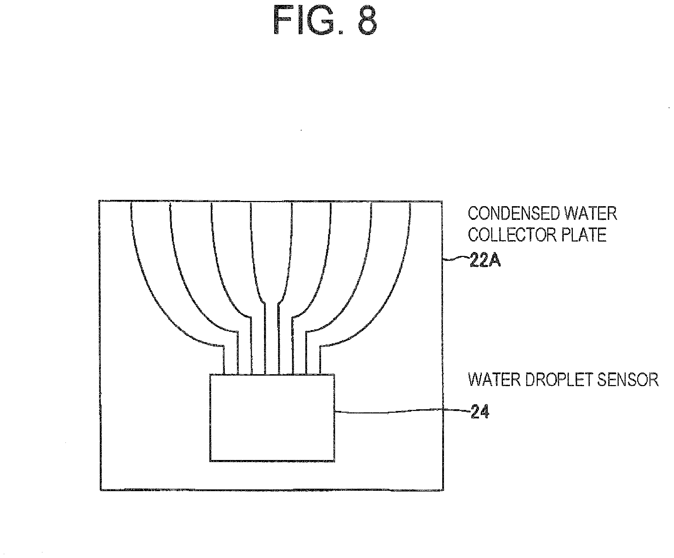

The recesses and protrusions or the grooves depicted in FIGS. 4 and 5 linearly extend in parallel to each other toward the edge where the water droplet sensor 24 is positioned but may alternatively be inclined or curved. FIG. 8 is a plan view of a condensed water collector plate 22A having curved recesses and protrusions or grooves. Each of the recesses and protrusions is curved and has one wider end and the other narrow end positioned at the water droplet sensor 24. The curved or inclined recesses and protrusions or grooves allow water droplets flowing along the recesses of the recesses and protrusions or the grooves to be efficiently guided to the water droplet sensor 24.

Further, in FIG. 2, the condensation sensing device 20 is disposed outside the water-cooled electronic device 12 but in the vicinity thereof. Alternatively, the condensation sensing device 20 may be disposed in the water-cooled electronic device 12 when the water-cooled electronic device 12 may provide an enough space therein.

A second embodiment will next be described. An electronic apparatus according to the second embodiment is substantially the same as the electronic apparatus according to the first embodiment but differs therefrom only in terms of the recesses and protrusions of the condensed water collector plate. No description of the same portions will therefore be made.

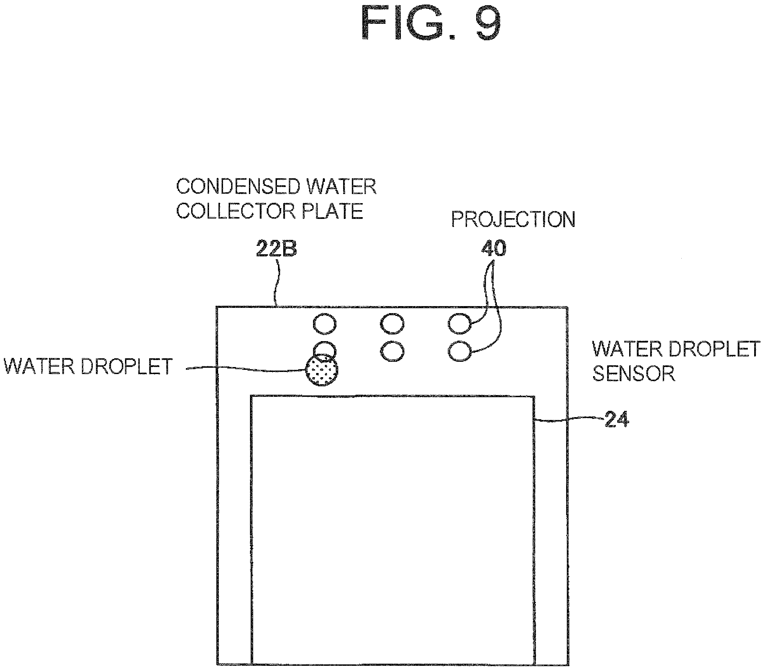

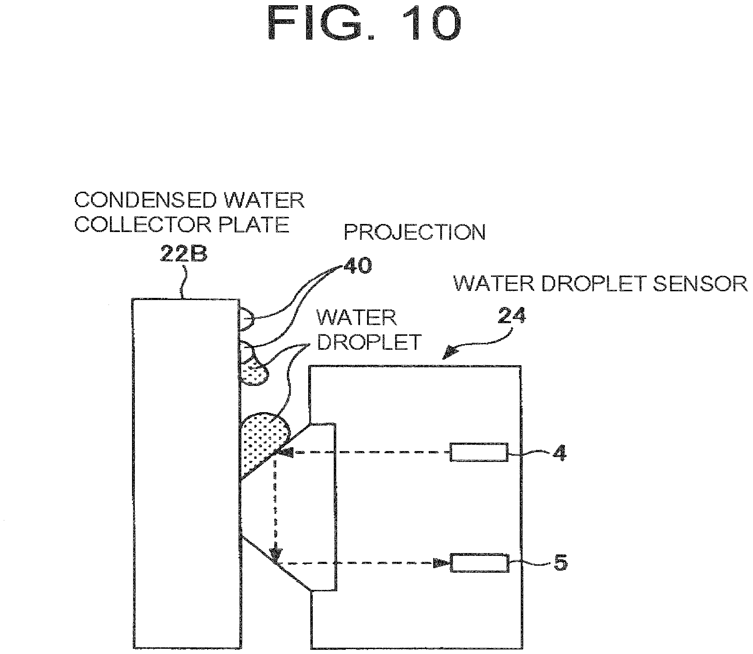

FIG. 9 is a front view of a condensed water collector plate 22B according to the second embodiment. FIG. 10 is a side view of the condensed water collector plate 22B depicted in FIG. 9. A plurality of small projections (particulate portions) 30 provided on the surface of the condensed water collector plate 22B and above the water droplet sensor 24 correspond to recesses and protrusions according to the present embodiment. Each of the projections 40 is, for example, a portion hemispherically projecting from the surface of the condensed water collector plate 22B, and the diameter and the projecting height of each of the projections 30 is, for example, about 1 mm. The size of the projections 30 is determined based on the size of a water droplet produced by condensation on the surface of the condensed water collector plate 22B.

That is, the size of the projections 40 is set to be approximately equal to or slightly smaller than the size of a water droplet produced by condensation on the surface of the condensed water collector plate 22B and flowing down by gravity. In this way, a water droplet produced by condensation flows down along the surface before the water droplet grows and falls under its own weight. A water droplet produced by condensation and growing on each of the projections 40 hangs from the projection 40, which projects from the surface of the condensed water collector plate 22B. In this case, the strength at which the water droplet attaches to the projection is smaller than the strength at which a water droplet attaches to a flat surface. The water droplet that hangs from each of the projections 40 falls under its own weight before it grows large, whereby the period from the point when condensation starts to the point when the water droplet flows down is shorter than the period for a flat surface. The water droplet sensor 24 may therefore detect water droplets and sense the condensation more quickly.

As described above, forming a plurality of particulate projections 40 on the surface of the condensed water collector plate 22B, which is an example of the condensation producing section, not only allows the area of the surface where condensation occurs to increase but also allows the number of nuclei that form water droplets to increase. In this way, the surface density of water droplets that start flowing may be increased, and as a result, the period from the point when water droplets start flowing to the point when the water droplets flow out and are accumulated to a detectable amount may be shortened.

The shape of each of the projections 40 is not limited to hemispherical but may be any shape that projects from the surface and has the size described above. Further, a method for forming the projections 40 may be forging based on a die, casting in which a molten metal is injected into a mold, machining, or any other suitable method.

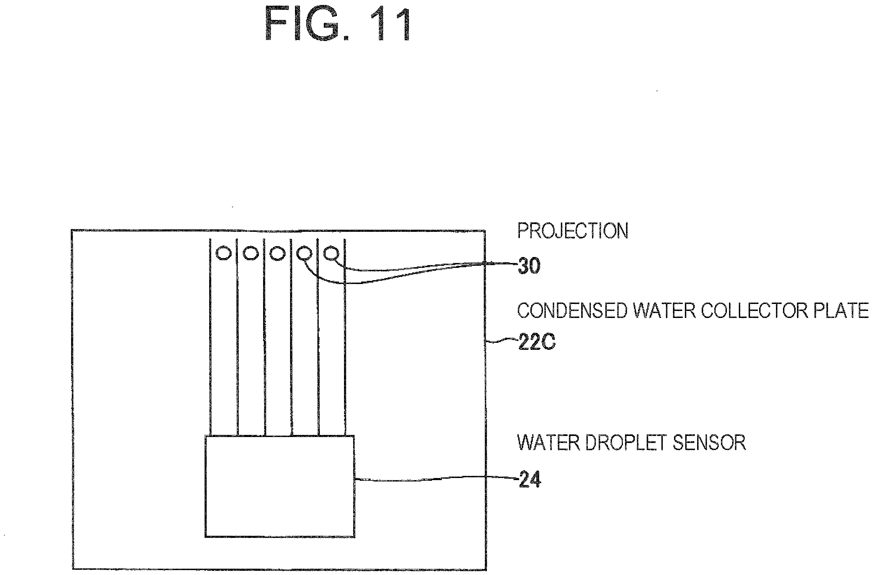

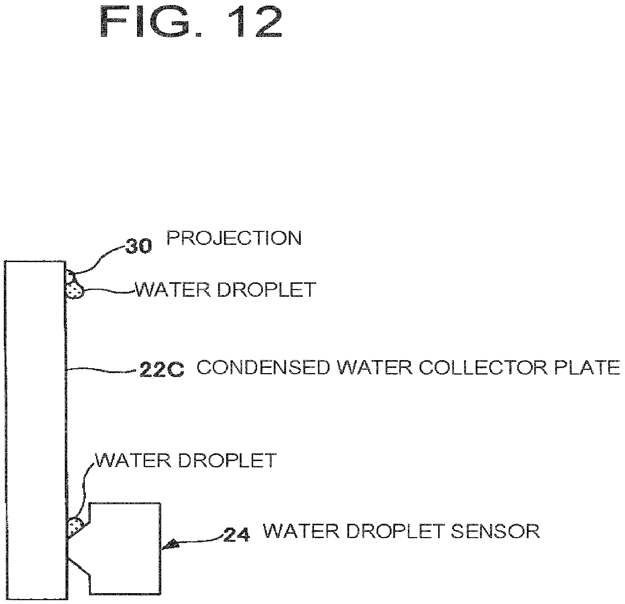

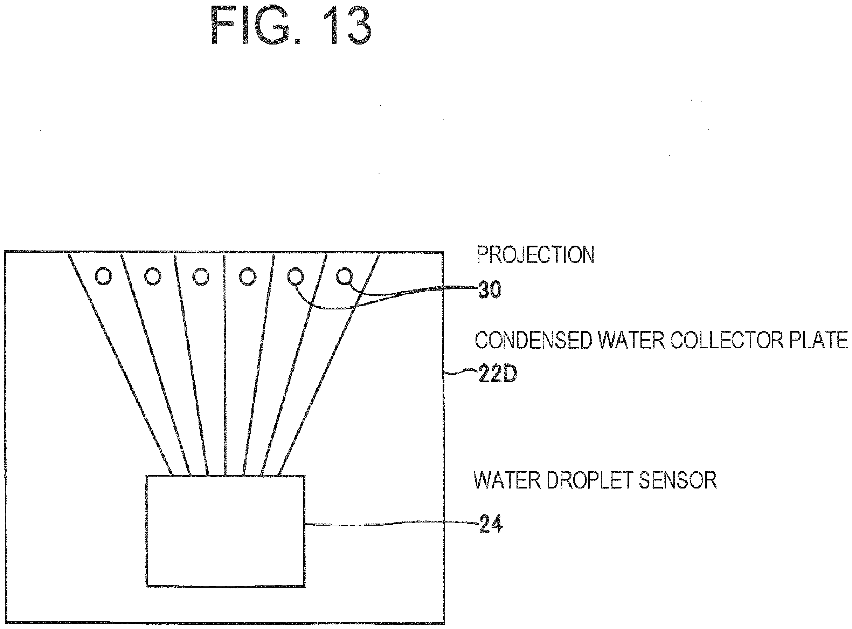

Adding the projections according to the second embodiment to the recesses and protrusions according to the first embodiment allows the period from the point when condensation starts to the point when the condensation is sensed may be further shortened. FIG. 11 is a front view of a condensed water collector plate 22C having groove-shaped recesses and protrusions on which small projections are further provided. FIG. 12 is a side view of the condensed water collector plate 22C depicted in FIG. 11. The recesses and protrusions or the grooves according to the first embodiment are formed on the surface of the condensed water collector plate 22C, and the projections 30 according to the second embodiment are provided on the recesses and protrusions or the grooves. FIG. 13 is a front view of a condensed water collector plate 22D having inclined recesses and protrusions or grooves extending therealong and projections provided on the recesses and protrusions or the grooves. The recesses and protrusions or the grooves are inclined and extend along the condensed water collector plate, and one side of the recesses and protrusions or the grooves faces the water droplet sensor 24.

## Claims

1. A condensation sensing device that detects a water droplet to sense the condensation, the condensation sensing device comprising:
a condensation producing section having a surface having recesses and protrusions; and
a water droplet detector that detects a water droplet guided by any of the recesses on the surface.

2. The condensation sensing device according to claim 1,
wherein the condensation sensing device is provided so that the surface extends in a direction that intersects a horizontal direction, and that the recesses and protrusions are disposed above the water droplet detector.

3. The condensation sensing device according to claim 1 or 2,
wherein the recesses and protrusions formed on the surface of the condensation producing section include a plurality of elongated recesses or grooves that extend in parallel to each other.

4. The condensation sensing device according to claim 1, 2 or 3,
wherein the recesses and protrusions formed on the surface of the condensation producing section include a plurality of elongated recesses or grooves that are curved or inclined and extend along the surface and one end of each of the recesses or the grooves faces the water droplet detecting section.

5. The condensation sensing device according to any preceding claim, further comprising:
a plurality of projections formed on the surface of the condensation producing section.

6. The condensation sensing device according to any preceding claim,
wherein the recesses and protrusions formed on the surface of the condensation producing section include a plurality of projections that project from the surface.

7. An electronic apparatus comprising:
a water-cooled electronic device having a cooling water tube provided therein;
a condensation sensing device disposed in the vicinity of the water-cooled electronic device; and
a cooled water supplier that supplies cooled water to the water-cooled electronic device via the condensation sensing device,
wherein the condensation sensing device includes:
a condensation producing section that has a surface where condensation occurs;
recesses and protrusions formed on the surface of the condensation producing section; and
a water droplet detecting section that detects water droplets produced by the condensation that occurs in the condensation producing section,
wherein the condensation sensing device is so installed that the surface of the condensation producing section extends in a direction that intersects a horizontal direction, and that the recesses and protrusions are disposed above the water droplet detecting section.

8. The electronic apparatus according to claim 7, further comprising:
a controller that shuts off the water-cooled electronic device based on a condensation detection signal from the condensation sensing device.

9. A condensation sensing method for sensing condensation in an electronic apparatus, the method comprising:
causing condensation to occur on a surface of a condensation producing section;
causing water droplets produced by the condensation to move along recesses and protrusions formed on the surface of the condensation producing section so that the water droplets are introduced into a water droplet detecting section; and
detecting the water droplets by using the water droplet detecting section and outputting a condensation detection signal.

10. The condensation sensing method according to claim 9, further comprising:
shutting off the electronic apparatus based on the condensation detection signal.
